# EUROPÄISCHE PATENTSCHRIFT

(11) **EP 1 708 870 B1**
(45) Veröffentlichungstag und Bekanntmachung des Hinweises auf die Patenterteilung: **24.03.2010**
(21) Anmeldenummer: 04802961.5
(22) Anmeldetag: 18.12.2004
(51) Int. Cl.: B30B 15/06, B32B 38/00

(54) **PRESSE ZUM HERSTELLEN VON LAMINATEN**
PRESS FOR THE PRODUCTION OF LAMINATES
PRESSE POUR LA FABRICATION DE STRATIFIES

(30) Priorität: 15.01.2004 DE 102004002075
(43) Veröffentlichungstag der Anmeldung: 11.10.2006
(73) Patentinhaber: Maschinenfabrik Lauffer GmbH & Co. KG, 72160 Horb (DE)
(72) Erfinder: MAI, Josef, 72160 Horb-Rexingen (DE)
(74) Vertreter: Späth, Dieter
(86) Internationale Anmeldenummer: PCT/DE2004/002775
(87) Internationale Veröffentlichungsnummer: WO 2005/068171

(56) Entgegenhaltungen:
- EP-A- 0 013 557
- WO-A-03/064156
- DE-A1- 4 116 324
- DE-B1- 2 535 383
- US-A- 5 942 066

## Beschreibung

Die Erfindung betrifft eine Presse zum Herstellen von Laminaten mit den Merkmalen des Oberbegriffs des Anspruchs 1. Mit Laminaten sind insbesondere Kunststoff- oder Plastiklaminate oder Kunststoff-Metall-Laminate gemeint, wie sie zur Herstellung von Multilayern (gedruckte Schaltungen) und für Kunststoffkarten wie Scheck-, Ausweis- oder Führerscheinkarten verwendet werden.

Eine derartige Presse ist bekannt aus der WO 03/064156 A1. Die bekannte Presse weist zwei Pressplatten auf, die zum Ausüben eines Pressdrucks auf ein zwischen ihnen befindliches Laminat gegeneinander beweglich sind. Das Laminat kann als Band oder in einzelnen Bögen zugeführt werden, es wird auf ein oder mehrere Prepreg-Bänder aufgelegt und der Presse zugeführt. Auf die Multilayer werden ebenfalls ein oder mehrere Prepreg-Bänder aufgelegt und der Presse zugeführt. Des Weiteren wird auf die Ober- und die Unterseite jeweils eine Kupferfolie aufgelegt, die in der Presse mittels der Prepreg Bänder auflaminiert werden. Zwischen einer unteren Pressplatte und der unteren Kupferfolie befindet sich eine Aluminiumfolie, die vor der Presse von einer Vorratsrolle abgewickelt und nach der Presse auf eine Rolle aufgewickelt wird. Die Aluminiumfolie dient als Transportband und als elektrische Widerstandsheizung. Sie ist über an Außenseiten der unteren Pressplatte angebrachte elektrische Kontakte an eine elektrische Stromquelle angeschlossen. Bei Versuchen hat sich gezeigt, dass es durch Abbrand im Bereich der eiektrischen Kontakte zu Kontaktproblemen kommen kann, eine Bestromung der Aluminiumfolie und damit die Heizwirkung verschlechtern sich. Des Weiteren verursachen Abbrandrückstände Unebenheiten der Aluminiumfolie, die die Press- und Laminierqualität beeinträchtigen.

Die EP 0 013 557 A2 offenbart eine Presse zum Herstellen von Laminaten. Zum Heizen weisen Pressplatten der bekannten Presse Heizelemente auf, die als flächenhafte Heizwiderstandsschichten auf einer dem Pressgut zugewandten Pressfläche der Stempel ausgeführt sein können. Bei Beschädigung oder Abnutzung lassen sich die Heizelemente nicht von den Pressplatten entfernen, es müssen die Pressplatten ausgetauscht werden.

Die DE 41 16 324 A1 offenbart eine Presse zum Kleben und/oder Formen von flachen Werkstücken, insbesondere von Textilien. Diese Presse weist keine gegeneinander beweglichen Pressplatten auf, sondern das Werkstück wird durch Druckbeaufschlagung einer dehnbaren Membran gegen eine feststehende Pressplatte gedrückt. Zum Heizen ist eine elektrisch leitende Widerstandsschicht auf der feststehende Pressplatte aufgebracht.

Die DE-A-25 35 383 offenbart eine Presse zum Herstellen von Laminaten aus kunstharzimprägnierten Papieren. Zum Pressen werden die zu laminierenden Papiere gestapelt, wobei zwischen jedes Presspaket ein elektrisch heizbares Pressblech gelegt wird. Die Presspakete sind die zu laminierenden Papiere.

Eine mit der vorstehende Presse vergleichbare Presse offenbart die US-A-5,942,066, bei der das Pressgut ebenfalls gestapelt wird und zwischen die einzelnen Presspakete elektrische Widerstandsheizplatten gelegt werden. Für diese Presse ist zum Herstellen plattenförmiger Flüssigkristallelemente vorgesehen.

Der Erfindung liegt die Aufgabe zugrunde, eine Presse mit gegeneinander beweglichen Pressplatten vorzuschlagen, deren Pressflächen mit wenig Aufwand wechselbar sind.

Diese Aufgabe wird erfindungsgemäß durch die Merkmale des Anspruchs 1 gelöst. Die erfindungsgemäße Presse weist eine Heizfolie auf, die fest auf einer dem Laminat zugewandten Oberfläche der Pressplatte angeordnet ist und die sich nicht mit dem Laminat mitbewegt. Die Heizfolie ist wechselbar, sie lässt sich bei Verschmutzung, Abnutzung oder Beschädigung leicht wechseln. Es kann eine solche Heizfolie an einer oder an beiden Pressplatten vorgesehen sein. Die Heizfolie ist an eine elektrische Stromquelle angeschlossen und wird zumindest während des Pressens mit Strom beaufschlagt. Sie wirkt als elektrische Widerstandsheizung und erwärmt das Laminat während des Pressens. Dabei muss die Heizfolie nicht zwingend dünn und flexibel sein, sie kann auch vergleichsweise dick und steif sein, die Verwendung eines Blechs als Heizfolie im Sinne der Erfindung ist denkbar. Die Erfindung hat den Vorteil, dass sich die Heizfolie dauerhaft und gut, insbesondere elektrisch gut leitend und mit geringem Übergangswiderstand an die Stromquelle anschließen lässt, so dass Kontaktabbrand weitestgehend ausgeschlossen ist. Weiterer Vorteil ist, dass solcher Kontaktabbrand, falls er doch entstehen sollte, nicht auf die Pressfläche transportiert wird, weil die Heizfolie fest an der Pressplatte angeordnet ist und sich nicht mit dem Laminat mitbewegt.

Für die Heizfolie sind unterschiedliche Materialien möglich, die sich bei Stromdurchfluss erwärmen und damit als Heizung dienen können. Eine bevorzugte Ausgestaltung der Erfindung sieht eine Stahlfolie als Heizfolie vor, die eine im Vergleich zu beispielsweise Kupfer oder Aluminium harte Pressfläche aufweist, was als Vorteil für das Laminieren angesehen wird.

Weiterer Vorteil der Heizfolie ist, dass sie sich bei Verschmutzung, Abnutzung oder Beschädigung leicht wechseln lässt, so dass wieder eine einwandfreie Pressfläche zur Verfügung steht.

Eine Ausgestaltung der Erfindung sieht ein elektrisch nicht leitendes Transportband zum Transport des Laminats durch die Presse vor. Das Transportband ist zwischen den Pressplatten durchgeführt, es befindet sich zwischen der unteren Pressplatte und dem Laminat, das auf dem Transportband liegt. Das Transportband besteht aus einem Material, das bei Laminiertemperatur nicht schmilzt sondern immer noch eine für seinen Zweck ausreichende Festigkeit aufweist, und das beim Laminieren nicht mit dem Laminat verklebt. Das Transportband kann nach dem Laminieren am Laminat haften,es muss sich allerdings rückstandsfrei vom Laminat abziehen lassen. Das Transportband ist beispielsweise eine Polyesterfolie. Es kann auch ein Kunststoff-Kupferfolie als Transportband verwendet werden, wobei die Kupferfolie von der Kunststofffolie abziehbar ist. Die Kupferfolie wird beim Laminieren auf das Laminat laminiert und bildet eine Außenlage des Multilayers. Das Transportband hat den Vorteil, dass es eine saubere und einwandfreie Oberfläche zum Pressen des Laminats zur Verfügung stellt.

Eine Weiterbildung der Erfindung sieht vor, das Transportband als Einwegband zu verwenden und nur einmal durch die Presse durchzuführen. Dies hat den Vorteil, dass das Transportband fabrikneu ist, wenn es in die Presse gelangt und mit dem Laminat in Kontakt kommt. Ausschuss durch Verschmutzung der Oberfläche des Transportbandes wird dadurch vermieden.

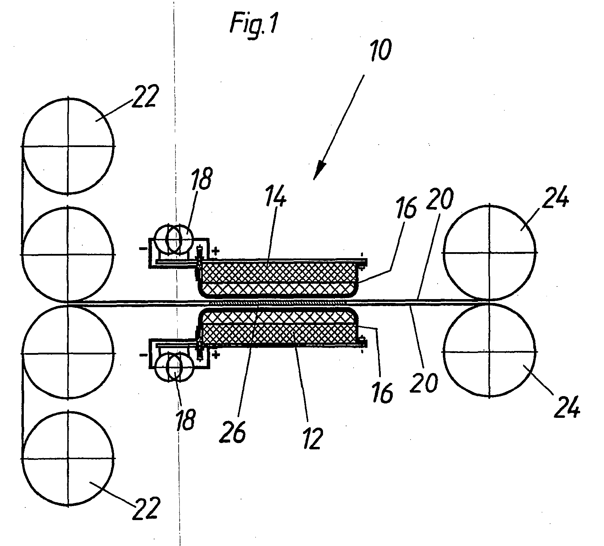

Die Erfindung wird nachfolgend anhand eines in der Zeichnung dargestellten Ausführungsbeispiels näher erläutert. Die einzige Figur zeigt eine Schemadarstellung einer erfindungsgemäßen Presse in Seitenansicht.

Die erfindungsgemäße Presse 10 weist eine feststehende untere Pressplatte 12 und eine bewegliche obere Pressplatte 14 auf, die zum Pressen auf die untere Pressplatte 12 absenkbar ist. Über einander zugewandte, nachfolgend Pressflächen 16 genannte Oberflächen der Pressplatten 12, 14 ist jeweils eine Stahlfolie als Heizfolie 16 gespannt. Die Heizfolien 16 sind an elektrische Spannungsquellen 18 angeschlossen und wirken als Widerstandheizungen. Die Pressplatten 12, 14 sind elektrisch isolierend oder weisen zumindest im Bereich der Pressflächen eine elektrisch nicht leitende Oberfläche auf. Die Pressplatten 12, 14 können beispielsweise aus eloxiertem Aluminium bestehen.

Zwischen den Pressplatten 12, 14 sind ein oberes und ein unteres Transportband 20 durchgeführt, die aus einem elektrisch nicht leitenden Material bestehen, dessen Schmelz- oder Erweichungstemperatur oberhalb einer Laminiertemperatur der Presse 10 liegt. Die Transportbänder 20 können beispielsweise Polyesterfolien sein. Die Transportbänder 20 werden von Vorratsrollen 22 abgewickelt und nach Durchlaufen der Presse 10 auf Aufwickelrollen 24 aufgewickelt. Die Transportbänder 20 gelangen somit fabrikneu in die Presse 10 und werden nur einmal verwendet.

Zwischen die Transportbänder 20 wird ein Laminiergut, beispielsweise zu laminierende Lagen eines Multilayers 26 eingebracht. Durch Antrieb der Aufwickelrollen 24-wird-der-Multilayer 26 mit den Transportbändern 20 zwischen die Pressplatten 12, 14 transportiert. Zum Pressen werden die Transportbänder 20 angehalten und durch Absenken der oberen Pressplatte 14 auf die untere Pressplatte 12 wird die Presse 10 geschlossen. Bei geschlossener Presse 10 werden die Heizfolien 16 bestromt und erwärmen sich aufgrund ihres elektrischen Widerstandes. Durch die Transportbänder 20 hindurch wird der Multilayer 26 auf eine Laminiertemperatur erwärmt und dabei von den Pressplatten 12, 14 mit einem Pressdruck beaufschlagt. Nach Erreichen der Laminiertemperatur wird die Bestromung der Heizfolien 16 ausgeschaltet. Die Presse 10 bleibt solange geschlossen, bis der Multilayer 26 soweit abgekühlt ist, dass er entnommen werden kann ohne dass die Gefahr besteht, dass sich seine Lagen gegeneinander verschieben oder voneinander lösen. Durch Anheben der oberen Pressplatte 14 wird die Presse 10 geöffnet und die Aufwickelrollen 24 werden angetrieben, so dass die Transportbänder 20 den laminierten Multilayer 26 aus der Presse 10 transportieren.

## Patentansprüche

1. Presse zum Herstellen von Laminaten, die zwei Pressplatten (12, 14) aufweist, die zum Ausüben eines Pressdrucks auf ein zwischen ihnen befindliches Laminat (26) gegeneinander beweglich sind, wobei mindestens eine der beiden Pressplatten (12, 14) eine wechselbare Heizfolie (16) auf ihrer dem Laminat (26) zugewandten Oberfläche (Pressfläche) aufweist, die an eine elektrische Stromquelle (18) angeschlossen ist und als elektrische Widerstandheizung wirkt, **dadurch gekennzeichnet, dass** die Heizfolie (16) fest auf der Oberfläche der Pressplatte (12, 14) angeordnet ist.

2. Presse nach Anspruch 1, **dadurch gekennzeichnet, dass** die Heizfolie (16) eine Stahlfolie ist.

3. Presse nach Anspruch 1 oder 2, **dadurch gekennzeichnet, dass** die Presse (10) ein elektrisch nicht leitendes Transportband (20) aufweist, das zwischen den Pressplatten (12, 14) durchgeführt ist und das sich zwischen einer der beiden Pressplatten (12, 14) und dem Laminat (26) befindet.

4. Presse nach Anspruch 3, **dadurch gekennzeichnet, dass** das Transportband (20) nur einmal durch die Presse (10) durchgeführt wird.

## Claims

1. Press for producing laminates, said press having two pressing plates (12, 14), which are moveable towards each other for exerting a pressing pressure onto a laminate (26) that is situated between them, wherein at least one of the two pressing plates (12, 14) has a changeable heating foil (16) on its surface (pressing surface) facing the laminate (26), said pressing surface being connected to an electric power source (18) and operating as electric resistance heating, **characterized in that** the heating foil (16) is located in a fixed manner on the surface of the pressing plate (12, 14).

2. Press according to Claim 1, **characterized in that** the heating foil (16) is a steel foil.

3. Press according to Claim 1 or 2, **characterized in that** the press (10) has a non-electrically conducting conveyor belt (20), which is conducted between the pressing plates (12, 14) and which is situated between one of the two pressing plates (12, 14) and the laminate (26).

4. Press according to Claim 3, **characterized in that** the conveyor belt (20) is only conducted once through the press (10).

## Revendications

1. Presse pour la fabrication de stratifiés, qui présente deux plaques de pressage (12, 14) qui sont mobiles l'une vers l'autre afin d'exercer une pression de pressage sur un stratifié (26) qui se trouve entre elles, sachant qu'au moins une des deux plaques de pressage (12, 14) présente une feuille de chauffe interchangeable (16) sur sa surface (face de pressage) tournée vers le stratifié (26), feuille qui est raccordée à une source de courant électrique (18) et joue le rôle de chauffage par résistance électrique, **caractérisée en ce que** la feuille de chauffe (16) est disposée fixement sur la surface de la plaque de pressage (12, 14).

2. Presse selon la revendication 1, **caractérisée en ce que** la feuille de chauffe (16) est une feuille d'acier.

3. Presse selon la revendication 1 ou 2, **caractérisée en ce que** la presse (10) présente une bande transporteuse (20) électriquement non conductrice, que l'on fait passer entre les plaques de pressage (12, 14) et qui se trouve entre une des deux plaques de pressage (12, 14) et le stratifié (26).

4. Presse selon la revendication 3, **caractérisée en ce qu'**on ne fait passer la bande transporteuse (20) qu'une seule fois à travers la presse (10).
